# EUROPEAN PATENT APPLICATION

(11) **EP 4 247 139 A1**
(43) Date of publication of application: **20.09.2023**
(21) Application number: 23159790.7
(22) Date of filing: 02.03.2023
(51) Int. Cl.: H10K 59/121, H10K 59/123, H10K 59/131, H10K 59/80

(54) **DISPLAY DEVICE AND METHOD OF PROVIDING THE SAME**

(30) Priority: 16.03.2022 KR 20220032702
(71) Applicant: Samsung Display Co., Ltd., Yongin-si, Gyeonggi-do 17113 (KR)
(72) Inventor: HWANG, DO YEON, Nowon-gu (KR); KIM, KWANG-MIN, Seoul (KR); KIM, KIWOOK, Hwaseong-si (KR)
(74) Representative: Taor, Simon Edward William

(57) **Abstract**

A display device includes a transistor, a first pixel electrode connected to the transistor, a second pixel electrode adjacent to the first pixel electrode and connectable to the first pixel electrode by a global transistor, a connection pattern of the global transistor, the connection pattern contacting the first pixel electrode and the second pixel electrode, an insulation film on the first pixel electrode, the second pixel electrode and the connection pattern, and a signal line of the global transistor, on the insulation film and crossing the connection pattern, in a plan view.

## Description

### BACKGROUND

### 1. FIELD

Embodiments relate to a display device. More particularly, embodiments relate to a display device and a method of manufacturing (or providing) the same.

### 2. DESCRIPTION OF THE RELATED ART

The display device is a device which displays an image for providing visual information to outside the display device, such as to a user. As a thickness and weight of the display device decrease, uses of the display device are diversifying.

The display device may provide different visual information depending on the viewing angle. In general, a display device is manufactured (or provided) to implement a wide viewing angle, but implementing a narrow viewing angle may be desired so that a display screen of the display device is viewable only at a predetermined position relative to the display screen.

### SUMMARY

Embodiments provide a display device capable of adjusting a viewing angle without reducing resolution.

Other embodiments provide a method of manufacturing (or providing) the display device.

A display device according to an embodiment includes a substrate, a transistor disposed on the substrate, a first pixel electrode disposed on the transistor and connected to the transistor, a second pixel electrode disposed on the transistor and adjacent to the first pixel electrode, a connection pattern contacting the first pixel electrode and the second pixel electrode, an insulation film disposed on the first pixel electrode, the second pixel electrode, and the connection pattern and a signal line disposed on the insulation film and crossing the connection pattern in a plan view.

In an embodiment, the signal line may be spaced apart from the first pixel electrode and the second pixel electrode in a plan view, and may be disposed between the first pixel electrode and the second pixel electrode.

In an embodiment, the signal line may have a mesh shape.

In an embodiment, the first pixel electrode and the second pixel electrode may be disposed on the same layer and include the same material.

In an embodiment, the connection pattern may include Indium-Gallium-Zinc Oxide (IGZO).

In an embodiment, the display device may further include a bridge pattern disposed on the transistor and disposed under the first pixel electrode, and the bridge pattern may contact the first pixel electrode and the transistor and be spaced apart from the second pixel electrode.

In an embodiment, the transistor may include an active layer disposed on the substrate and a gate electrode disposed on the active layer and overlapping the active layer.

In an embodiment, the signal line may include the same material as the gate electrode.

In an embodiment, the display device may further include a pixel defining layer disposed on the insulation film and the signal line and defining a first opening overlapping the first pixel electrode and a second opening overlapping the second pixel electrode, a first light emitting layer disposed in the first opening, a second light emitting layer disposed in the second opening and a common electrode layer disposed on the first light emitting layer, the second light emitting layer, and the pixel defining layer.

In an embodiment, the display device may further include a first black matrix disposed on the common electrode layer and overlapping the first pixel electrode and a second black matrix disposed on the common electrode layer, overlapping the second pixel electrode, and spaced apart from the first black matrix.

In an embodiment, the first pixel electrode and the second pixel electrode may be adjacent each other in a first direction, the first black matrix may be disposed in a second direction crossing the first direction from a center of the first pixel electrode, and the second black matrix may be disposed in a third direction opposite to the second direction from a center of the second pixel electrode.

A display device according to an embodiment may include a plurality of pixels, and each of the plurality of the pixels emits light of color and includes a transistor, a first light emitting diode including a first anode terminal connected to the transistor, a global transistor including a global gate terminal to which a global signal is applied and connected to the first light emitting diode and a second light emitting diode including a second anode terminal connected to the global transistor.

In an embodiment, the global transistor may be turned on by the global signal.

In an embodiment, when the global transistor is turned off, current may flow in the first light emitting diode, and when the global transistor is turned on, the current may flow in the first light emitting diode and the second light emitting diode.

A method of manufacturing (or providing) a display device according to an embodiment may include forming a transistor on a substrate, forming a pixel electrode layer connected to the transistor on the transistor, forming a first pixel electrode and a second pixel electrode adjacent to the first pixel electrode by patterning the pixel electrode layer, forming a connection pattern contacting the first pixel electrode and the second pixel electrode on the first pixel electrode and the second pixel electrode, forming an insulation film on the first pixel electrode, the second pixel electrode, and the connection pattern and forming a signal line crossing the connection pattern in a plan view on the insulation film.

In an embodiment, the method may further include forming a pixel defining layer on the insulation film and the signal line, forming a first opening overlapping the first pixel electrode and a second opening overlapping the second pixel electrode in the pixel defining layer and forming a third opening overlapping the first opening and exposing the first pixel electrode and a fourth opening overlapping the second opening and exposing the second pixel electrode.

In an embodiment, the method may further include forming a common electrode layer on the pixel defining layer, forming a first black matrix overlapping the first pixel electrode on the common electrode layer and forming a second black matrix overlapping the second pixel electrode on the common electrode layer.

In an embodiment, the forming the signal line may include forming a conductive layer on the insulation film and forming a mesh shape by patterning the conductive layer.

In an embodiment, the signal line may be spaced apart from the first pixel electrode and the second pixel electrode in a plan view, and may be disposed between the first pixel electrode and the second pixel electrode.

In an embodiment, the connection pattern may be formed of Indium-Gallium-Zinc Oxide (IGZO).

According to an aspect, there is provided a display device as set out in claim 1. Additional features are set out in claims 2 to 8. According to an aspect, there is provided a display device as set out in claim 9. Additional features are set out in claim 10. According to an aspect, there is provided a method as set out in claim 11. Additional features are set out in claim 12 to 15.

In a display device according to embodiments of the invention, as the sub-pixel which emits light of a single color and is included in the display device includes the first pixel electrode and the second pixel electrode connectable or disconnectable to and from each other, respectively, and includes a global transistor connecting and disconnecting the first pixel electrode and the second pixel electrode, the first light emitting diode including the first pixel electrode and the second light emitting diode including the second pixel electrode may selectively emit light by the global signal applied to the global transistor. Accordingly, it may be possible to adjust the viewing angle of the display device without reducing the resolution of the display device.

As the global transistor connected to the first light emitting diode and the second light emitting diode is turned on or off in response to the global signal, the second light emitting diode may receive the driving current even without a separate transistor. Accordingly, the display device including the pixels may adjust the viewing angle without reducing resolution.

### BRIEF DESCRIPTION OF THE DRAWINGS

The above and other advantages and features of this disclosure will become more apparent by describing in further detail embodiments thereof with reference to the accompanying drawings, in which:
FIG. 1 is a plan view illustrating a display device according to an embodiment.
FIG. 2 is a plan view illustrating an enlarged area A of FIG. 1.
FIG. 3 is a plan view illustrating an enlarged area B of FIG. 2.
FIG. 4 is a cross-sectional view taken along line I-I' of FIG. 2.
FIG. 5 is a circuit diagram illustrating a pixel included in a display device according to an embodiment.
FIG. 6 is a circuit diagram illustrating an example of FIG. 5.
FIGS. 7 to 25 are views for explaining a method of manufacturing a display device according to an embodiment.

### DETAILED DESCRIPTION

Hereinafter, display devices in accordance with embodiments will be described in more detail with reference to the accompanying drawings. The same reference numerals are used for the same components in the drawings, and redundant descriptions of the same components will be omitted. As used herein, a reference number may indicate a singular element or a plurality of the element. For example, a reference number labeling a singular form of an element within the drawing figures may be used to reference a plurality of the singular element within the text of specification.

It will be understood that when an element is referred to as being related to another element such as being "on" another element, it can be directly on the other element or intervening elements may be present therebetween. In contrast, when an element is referred to as being related to another element such as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the

Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein. Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

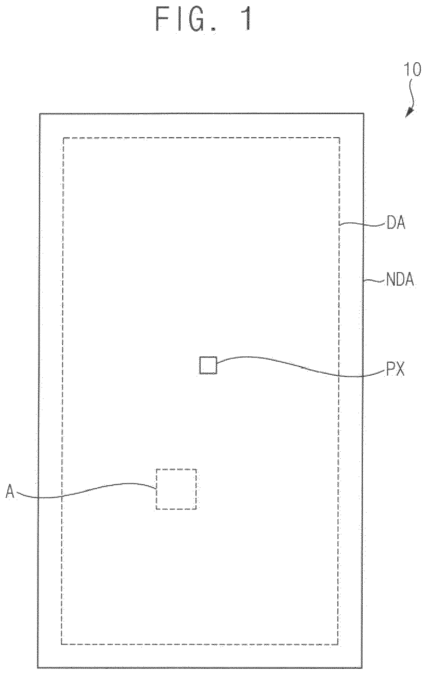

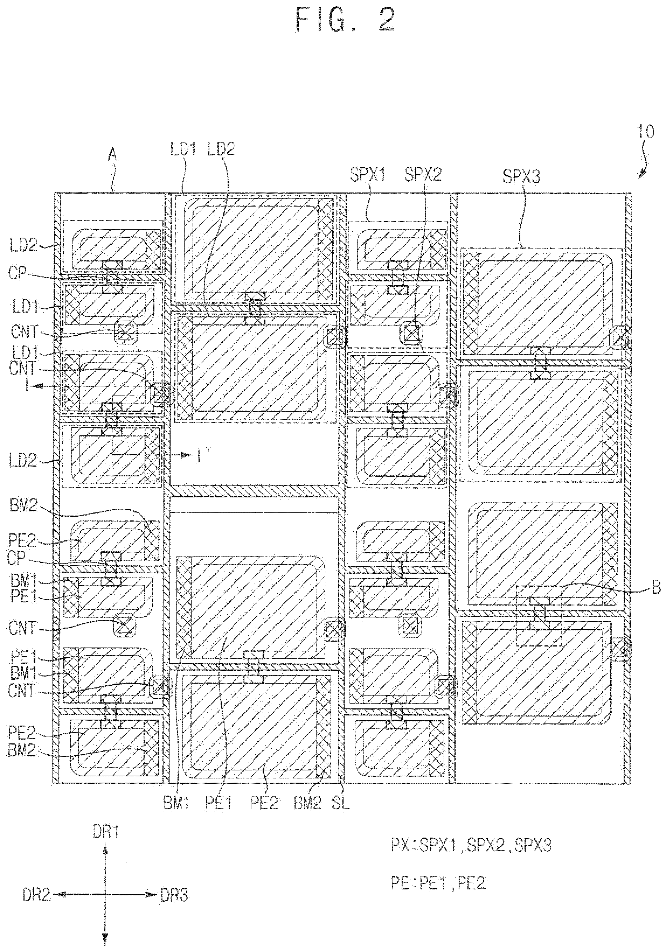

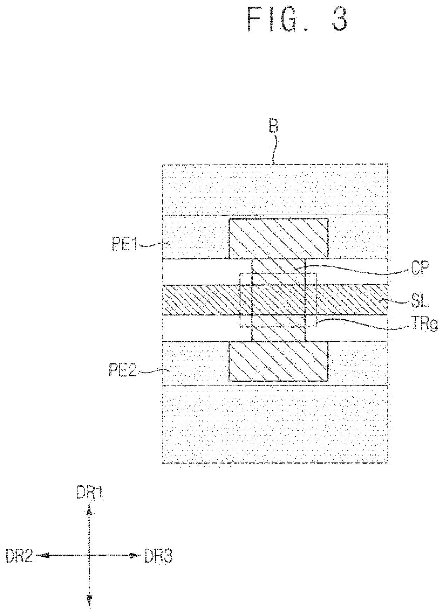

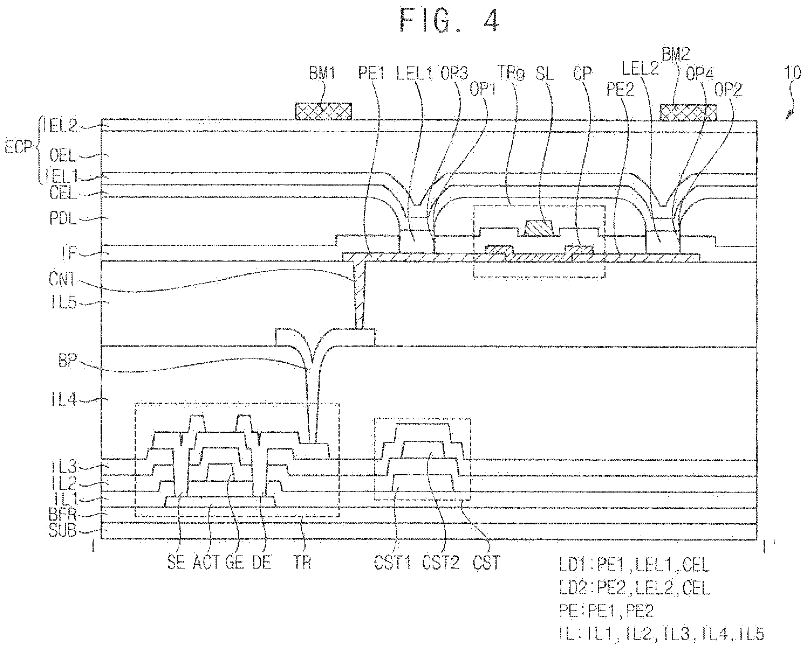

FIG. 1 is a plan view illustrating a display device 10 according to an embodiment. FIG. 2 is a plan view illustrating an enlarged area A of FIG. 1. FIG. 3 is a plan view illustrating an enlarged area B of FIG. 2. FIG. 4 is a cross-sectional view taken along line I-I' of FIG. 2.

Referring to FIG. 1, a display device 10 may include a display area DA and a non-display area NDA. The display area DA may display an image on a screen (e.g., a display screen) of the display device 10. A pixel PX provided in plural including a plurality of pixels PX which emit light to display the image, and lines (e.g., conductive line or electrical signal line) which transmit a driving signal as an electrical signal to the pixels PX may be disposed in the display area DA. Examples of the lines as electrical signal lines, include a gate line and a data line. The gate line may transmit a gate signal, and the data line may transmit a data signal.

The non-display area NDA may be an area (e.g., a planar area) which does not display an image. Lines for driving as electrical signal lines, and drivers, may be disposed in the non-display area NDA. For example, a gate driver, a light emitting driver, a pad, and a driving chip may be disposed in the non-display area NDA. The non-display area NDA may be adjacent to the display area DA, such as being adjacent to at least one side of the display area DA. In an embodiment, the non-display area NDA may surround the display area DA, such as being adjacent to all sides of the display area DA. However, embodiments according to the invention are not limited thereto, and an image may be also displayed in the non-display area NDA.

Referring to FIGS. 1 to 3, the display device 10 may include the pixels PX. Each of the pixels PX may include first to third sub-pixels SPX1, SPX2, and SPX3. The first to third sub-pixels SPX1, SPX2, and SPX3 may emit light of different colors from each other. The first sub-pixel SPX1 may emit a first light having a first color, the second sub-pixel SPX2 may emit a second light having a second color, and the third sub-pixel SPX3 may emit a third light having a third color. For example, the first color may be red, the second color may be green, and the third color may be blue. However, embodiments according to the invention are not limited thereto.

In an embodiment, each of the first to third sub-pixels SPX1, SPX2, and SPX3 may include a pixel electrode PE including two pixel electrodes PE1 and PE2. Accordingly, each of the first to third sub-pixels SPX1, SPX2, and SPX3 may include two light emitting elements such as two light emitting diodes LD1 and LD2. For example, each of the first to third sub-pixels SPX1, SPX2, and SPX3 may include a first light emitting diode LD1 and a second light emitting diode LD2. The first light emitting diode LD1 may include a first pixel electrode PE1. The second light emitting diode LD2 may include a second pixel electrode PE2. The first pixel electrode PE1 and the second pixel electrode PE2 may be adjacent to each other and overlap each other in (or along) a first direction DR1.

Each of the first to third sub-pixels SPX1, SPX2, and SPX3 may include at least one transistor (e.g., a transistor TR of FIG. 4) and a global transistor (e.g., a global transistor TRg of FIG. 4). The first pixel electrode PE1 included in the first light emitting diode LD1 may be directly connected to the transistor TR, and the second pixel electrode PE2 included in the second light emitting diode LD2 may not be directly connected to the transistor TR. The global transistor TRg may be directly connected to both of the first pixel electrode PE1 and the second pixel electrode PE2 of the different light emitting elements of a same pixel PX.

The transistor TR may control a driving current (e.g., electrical driving current) flowing in the light emitting diodes LD1 and LD2. The global transistor TRg may control a driving current flowing in the second light emitting diode LD2.

The first pixel electrode PE1 and the second pixel electrode PE2 may be connected to each other by a connection pattern CP. The first pixel electrode PE1 and the second pixel electrode PE2 may be adjacent to each other in the first direction DR1, and the connection pattern CP may extend in the first direction DR1, such as to have a major dimension along the first direction DR1, without embodiments being limited thereto.

The first pixel electrode PE1, the first light emitting layer LEL1, and the common electrode layer CEL may together constitute the first light emitting diode LD1, and the second pixel electrode PE2, the second light emitting layer LEL2, and the common electrode layer CEL together may constitute the second light emitting diode LD2.

In an embodiment, a signal line SL applying a global signal may be disposed between the first pixel electrode PE1 and the second pixel electrode PE2. The signal line SL may cross the connection pattern CP connecting the first pixel electrode PE1 and the second pixel electrode PE2, in a plan view.

The signal line SL may be spaced apart from the first pixel electrodes PE1 and the second pixel electrodes PE2, and may have a mesh shape, in the plan view. The signal line SL and the connection pattern CP may constitute portions of the global transistor TRg. Accordingly, the driving current may be provided to the second light emitting diode LD2 by the global signal transmitted through the signal line SL. The pixel electrode PE may have outer edges in the plan view, and the signal line SL spaced apart from the first pixel electrodes PE1 and the second pixel electrodes PE2 is spaced apart from the outer edges of the pixel electrode PE. The signal line SL may be spaced apart from the first pixel electrodes PE1 and the second pixel electrodes PE2 along one or more directions with respect to a plane defined by the first direction DR1 and a second direction DR2 crossing each other. As having a mesh shape, a plurality of solid portions of the signal line SL are spaced apart from each other to define a gap or space between the solid portions, in the plan view.

A first black matrix BM1 and a second black matrix BM2 of a black matrix layer, may be disposed on the common electrode layer CEL. The first black matrix BM1 and the second black matrix BM2 may be spaced apart from each other. The first black matrix BM1 may overlap (or correspond to) the first pixel electrode PE1, and the second black matrix BM2 may overlap (or correspond to) the second pixel electrode PE2, along a thickness direction which crosses each of the first, second and third directions DR1, DR2 and DR3.

With respect to the planar view of FIG. 2, the first black matrix BM1 may be disposed on the first pixel electrode PE1 in a second direction DR2 crossing the first direction DR1, from a center of the first pixel electrode PE1. The second black matrix BM2 may be disposed on the second pixel electrode PE2 in a third direction DR3 opposite to the second direction DR2, from a center of the second pixel electrode PE2. For example, the first direction DR1 may be perpendicular to the second direction DR2 and the third direction DR3, respectively. However, embodiments according to the invention are not limited thereto. The first and second black matrices BM1 and BM2 of a same sub-pixel, may be disposed at opposing ends of the pixel PX. In an embodiment, the first pixel electrode PE1 and the second pixel electrode PE2 are adjacent each other along a first direction DR1, each of the first pixel electrode PE1 and the second pixel electrode PE2 includes a first end and a second end opposing each other along a second direction DR2 (or a third direction DR3) crossing the first direction DR1, the first black matrix BM1 overlaps the first end of the first pixel electrode PE1, and the second black matrix BM2 overlaps the second end of the second pixel electrode PE2.

The first black matrix BM1 and the second black matrix BM2 may function to block and/or absorb light. Accordingly, the first black matrix BM1 may adjust a viewing angle of the first light emitting diode LD1, and the second black matrix BM2 may adjust a viewing angle of the second light emitting diode LD2.

In an embodiment, as each of the first to third sub-pixels SPX1, SPX2, and SPX3 includes the first pixel electrode PE1 and the second pixel electrode PE2, and the global transistor TRg connecting the first pixel electrode PE1 and the second pixel electrode PE2 to each other, the first light emitting diode LD1 including the first pixel electrode PE1 and the second light emitting diode LD2 including the second pixel electrode PE2 may selectively emit light by the global signal. Accordingly, the viewing angle of the display device 10 may be adjusted without reducing the resolution of the display device 10.

Referring further to FIG. 4, the display device 10 may include a substrate SUB, a buffer layer BFR, at least one transistor TR, a storage capacitor CST, insulation layers IL, and a bridge pattern BP, a first pixel electrode PE1, a second pixel electrode PE2, a connection pattern CP, an insulation film IF, a signal line SL, a pixel defining layer PDL, a first light emitting layer LEL1, a second light emitting layer LEL2, a common electrode layer CEL, an encapsulation layer ECP, a first black matrix BM1, and a second black matrix BM2.

The transistor TR may be disposed on the substrate SUB and may include an active layer ACT, a gate electrode GE, a source electrode SE, and a drain electrode DE. The storage capacitor CST may include a first capacitor electrode CST1 and a second capacitor electrode CST2. The insulation layers IL may include first to fifth insulation layers IL1, IL2, IL3, IL4, and IL5. The encapsulation layer ECP may include a first inorganic encapsulation layer IEL1, an organic encapsulation layer OEL, and a second inorganic encapsulation layer IEL2.

The substrate SUB may be formed of (or include) glass, quartz, plastic, or the like. The buffer layer BFR may be disposed on the substrate SUB. The buffer layer BFR may prevent diffusion of metal atoms or impurities from the substrate SUB to the active layer ACT.

The active layer ACT may be disposed on the buffer layer BFR. The active layer ACT may be divided into a source region and a drain region doped with impurities, and a channel region between the source region and the drain region.

The first insulation layer IL1 may be disposed on the buffer layer BFR. The first insulation layer IL1 may cover the active layer ACT and may be formed (or provided) to have substantially the same thickness along a profile of the active layer ACT. However, embodiments of the invention are not limited thereto. For example, the first insulation layer IL1 may include an inorganic material.

The gate electrode GE and the first capacitor electrode CST1 may be disposed on the first insulation layer IL1. In an embodiment, the gate electrode GE may overlap the channel region of the active layer ACT. The gate electrode GE and the first capacitor electrode CST1 may be considered in a same layer as each other. As being in or on a same layer, elements may be respective portions of a same material layer, may be on a same layer by forming an interface with a same underlying or overlying layer, may be provided or formed in a same process and/or as including a same material, etc., without embodiments being limited thereto.

The second insulation layer IL2 may be disposed on the first insulation layer IL1. In addition, the second insulation layer IL2 may cover the gate electrode GE and the first capacitor electrode CST1, and may be disposed to have substantially the same thickness along profiles of gate electrode GE and the first capacitor electrode CST1. However, embodiments of the invention are not limited thereto.

The second capacitor electrode CST2 may be disposed on the second insulation layer IL2. In an embodiment, the second capacitor electrode CST2 may overlap the first capacitor electrode CST1, and the first capacitor electrode CST1 and the second capacitor electrode CST2 may together constitute the storage capacitor CST.

The third insulation layer IL3 may be disposed on the second insulation layer IL2. Also, the third insulation layer IL3 may cover the second capacitor electrode CST2 and may be disposed to have substantially the same thickness along a profile of the second capacitor electrode CST2. However, embodiments of the invention are not limited thereto.

The source electrode SE and the drain electrode DE may be disposed on the third insulation layer IL3. The source electrode SE may contact the source region of the active layer ACT through (or at) a first contact hole formed in (or defined extended through) the first to third insulation layers IL1, IL2, and IL3. The drain electrode DE may contact the drain region of the active layer ACT through a second contact hole formed in the first to third insulation layers IL1, II,2, and IL3. As being in contact, elements may form an interface therebetween, without embodiments being limited thereto.

The fourth insulation layer IL4 may be disposed on the third insulation layer IL3. In addition, the fourth insulation layer IL4 may cover the source and drain electrodes SE and DE, and may have a substantially flat upper surface without creating a step around the source and drain electrodes SE and DE, owing to the uneven profiles thereof. For example, the fourth insulation layer IL4 may include an organic material.

The bridge pattern BP may be disposed on the fourth insulation layer IL4. The bridge pattern BP may contact the source electrode SE or the drain electrode DE through a third contact hole formed in the fourth insulation layer IL4.

The fifth insulation layer IL5 may be disposed on the fourth insulation layer IL4. Also, the fifth insulation layer IL5 may cover the bridge pattern BP, and may have a substantially flat upper surface without creating a step around the bridge pattern BP. For example, the fifth insulation layer IL5 may include an organic material.

The first pixel electrode PE1 and the second pixel electrode PE2 may be disposed on the fifth insulation layer IL5. The first pixel electrode PE1 and the second pixel electrode PE2 may be disposed on the same layer and may include the same material. The first pixel electrode PE1 and the second pixel electrode PE2 may have reflective or transmissive properties. For example, the first pixel electrode PE1 and the second pixel electrode PE2 may include a metal.

The first pixel electrode PE1 may contact the bridge pattern BP through a contact hole CNT formed in the fifth insulation layer IL5. Through this, the first pixel electrode PE1 may be directly connected to the transistor TR. In an embodiment, the transistor TR may be considered to include the bridge pattern BP, such that the first pixel electrode PE1 is disclosed as being directly connected to the transistor TR. That is, the bridge pattern BP may be considered as determining a direct connection or an indirect connection between elements.

The second pixel electrode PE2 may be adjacent to the first pixel electrode PE1 and may be spaced apart from the bridge pattern BP in a direction along the insulation film IF. That is, the second pixel electrode PE2 may not contact the bridge pattern BP, and the second pixel electrode PE2 may not be directly connected to the transistor TR.

The connection pattern CP may be disposed on the fifth insulation layer IL5 and may contact the first pixel electrode PE1 and the second pixel electrode PE2. The connection pattern CP may connect the first pixel electrode PE1 and the second pixel electrode PE2 to each other, as being extended between (and in contact with each of) the first pixel electrode PE1 and the second pixel electrode PE2.

The connection pattern CP may include a semi-conductive material. For example, the connection pattern CP may include Indium-Gallium-Zinc Oxide (IGZO).

The insulation film IF may be disposed on the fifth insulation layer IL5. In addition, the insulation film IF may be disposed on the first pixel electrode PE1, the second pixel electrode PE2, and the connection pattern CP, and may cover the first pixel electrode PE1, the second pixel electrode PE2, and the connection pattern CP.

The insulation film IF may be disposed to have substantially the same thickness along the profiles of the first pixel electrode PE1, the second pixel electrode PE2, and the connection pattern CP. However, embodiments of the invention are not limited thereto. For example, the insulation film IF may include an inorganic material.

The signal line SL may be disposed on the insulation film IF. The signal line SL may be disposed between the first pixel electrode PE1 and the second pixel electrode PE2 in the plan view, and the first pixel electrode PE1 and the second pixel electrode PE2 may cross the connection pattern CP connecting the first pixel electrode PE1 and the second pixel electrode PE2. The signal line SL may be spaced apart from the first pixel electrode PE1 and the second pixel electrode PE2 in the plan view and may partially overlap the connection pattern CP.

The signal line SL may include the same material as the gate electrode GE included in the transistor TR. However, embodiments according to the invention are not limited thereto. Examples of the material constituting the gate electrode GE and the signal line SL may include silver (Ag), an alloy containing silver, molybdenum (Mo), an alloy containing molybdenum, aluminum (Al), an alloy containing aluminum, aluminum nitride (AlN), tungsten (W), tungsten nitride (WN), copper (Cu), nickel (Ni), chromium (Cr), chromium nitride (CrN), titanium (Ti), tantalum (Ta), platinum (Pt), scandium (Sc), indium tin oxide (ITO), indium zinc oxide (IZO), etc. These materials may be used alone or in combination.

The connection pattern CP and the signal line SL may constitute portions of a global transistor TRg. The global transistor TRg may receive a global signal as an electrical signal, and the second light emitting diode LD2 may receive a driving current by the global signal. In an embodiment, the display device 10 may include a plurality of pixels PX (or sub-pixels) emitting light of different colors from each other, and each pixel PX (or sub-pixel) among the plurality of the pixels PX may include a transistor TR through which electrical current is provided to the each pixel PX, a first light emitting diode LD1 connected to the transistor TR, a second light emitting diode LD2 adjacent to the first light emitting diode LD1 and connectable to the first light emitting diode LD1, and the global transistor TRg which receives an electrical signal (e.g., the global signal) and is connected to the first light emitting diode LD1. The global transistor TRg is turned on by receiving the electrical signal and is turned off by absence of the electrical signal. The global transistor TRg which is turned off, disconnects the second light emitting diode LD2 from the first light emitting diode LD1, and the electrical current flows in the first light emitting diode LD1, and the global transistor TRg which is turned on, connects the second light emitting diode LD2 to the first light emitting diode LD1, and the electrical current flows in both the first light emitting diode LD1 and the second light emitting diode LD2.

The pixel defining layer PDL may be disposed on the insulation film IF. Also, the pixel defining layer PDL may be disposed on the signal line SL and may cover the signal line SL.

A first opening OP1 overlapping the first pixel electrode PE1 and a second opening OP2 overlapping the second pixel electrode PE2, may be defined in or defined by the pixel defining layer PDL. A third opening OP3 overlapping (or aligned with) the first opening OP1 and a fourth opening OP4 overlapping (or aligned with) the second opening OP2 may be defined in or by the insulation film IF. For example, the pixel defining layer PDL may include an organic material or an inorganic material. The respective openings which are aligned with each other, may expose a respective pixel electrode to outside the pixel defining layer PDL and the insulation film IF, within a same sub-pixel.

The first light emitting layer LEL1 may be disposed on the first pixel electrode PE1, and the second light emitting layer LEL2 may be disposed on the second pixel electrode PE2. The first light emitting layer LEL1 may be disposed in the first opening OP1 defined in the pixel defining layer PDL and the third opening OP3 defined in the insulation film IF. The second light emitting layer LEL2 may be disposed in the second opening OP2 defined in the pixel defining layer PDL and the fourth opening OP4 defined in the insulation film IF. In an embodiment, each of the first light emitting layer LEL1 and the second light emitting layer LEL2 may have a multilayer structure including a hole injection layer, a hole transport layer, an organic light emitting layer, an electron transport layer, and an electron injection layer. The organic light emitting layer may include a light emitting material.

The common electrode layer CEL may cover the first light emitting layer LEL1 and the second light emitting layer LEL2 and may be disposed on the pixel defining layer PDL, the first light emitting layer LEL1 and the second light emitting layer LEL2. In an embodiment, the common electrode layer CEL may have a plate shape. In addition, the common electrode layer CEL may have transmissive or reflective properties. For example, the common electrode layer CEL may include a metal.

The first pixel electrode PE1, the first light emitting layer LEL1, and the common electrode layer CEL may constitute portions of a first light emitting diode LD1, and the second pixel electrode PE2, the second light emitting layer LEL2, and the common electrode layer CEL may constitute portions of a second light emitting diode LD2. Since the first light emitting diode LD1 and the second light emitting diode LD2 include the first pixel electrode PE1 and the second pixel electrode PE2, respectively, the first light emitting diode LD1 and the second light emitting diode LD2 may emit light separately from each other.

The encapsulation layer ECP may prevent moisture and oxygen from penetrating into the light emitting diode from the outside. For example, the encapsulation layer ECP may include a first inorganic encapsulation layer IEL1, an organic encapsulation layer OEL, and a second inorganic encapsulation layer IEL2.

The first inorganic encapsulation layer IEL1 may be disposed on the common electrode layer CEL to have substantially the same thickness along a profile of the common electrode layer CEL. The organic encapsulation layer OEL may be disposed on the first inorganic encapsulation layer IEL1, and may have a substantially flat upper surface without creating a step around the first inorganic encapsulation layer IEL1. The second inorganic encapsulation layer IEL2 may be disposed on the organic encapsulation layer OEL.

The first black matrix BM1 and the second black matrix BM2 may be disposed on the encapsulation layer ECP. The second black matrix BM2 may be spaced apart from the first black matrix BM1. The first black matrix BM1 and the second black matrix BM2 may function to block and/or absorb light. Accordingly, each of the first black matrix BM1 and the second black matrix BM2 may include a black pigment, a black dye, or a conductive material.

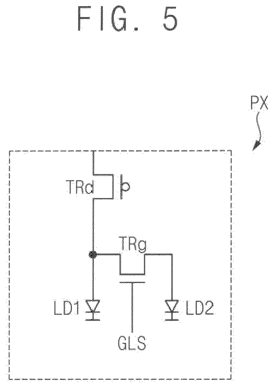

FIG. 5 is a circuit diagram illustrating a pixel PX included in a display device 10 according to an embodiment.

Referring to FIGS. 1 and 5, the display device 10 may include a plurality of pixels PX. Each of the pixels PX may include a driving transistor TRd, a first light emitting diode LD1, a global transistor TRg, and a second light emitting diode LD2.

The driving transistor TRd may include a first gate terminal, a first source terminal, and a first drain terminal. The first drain terminal of the driving transistor TRd may be connected to the first light emitting diode LD1.

The first light emitting diode LD1 may include a first anode terminal and a first cathode terminal. The first anode terminal of the first light emitting diode LD1 may be connected to the driving transistor TRd.

The global transistor TRg may include a global gate terminal, a global source terminal, and a global drain terminal. A global signal GLS may be applied to the global gate terminal of the global transistor TRg. The global source terminal of the global transistor TRg may be connected to the first light emitting diode LD1, and the global drain terminal may be connected to the second light emitting diode LD2. The global gate terminal may be turned on and off by the global signal GLS. That is, the second pixel electrode PE2 which is adjacent to the first pixel electrode PE1, is connectable to the first pixel electrode PE1 by the global transistor TRg.

The second light emitting diode LD2 may include a second anode terminal and a second cathode terminal. The second anode terminal of the second light emitting diode LD2 may be connected to the global transistor TRg.

In an embodiment, when the global transistor TRg is turned off by the global signal GLS, current (e.g., electrical current) may flow only in the first light emitting diode LD1. That is, no current may flow in the second light emitting diode LD2 when the global transistor TRg is turned off by the global signal GLS. Accordingly, the second light emitting diode LD2 may not emit light, and only the first light emitting diode LD1 may emit light.

When the global transistor TRg is turned on by the global signal GLS, current may flow in the first light emitting diode LD1 and the second light emitting diode LD2. Accordingly, both the first light emitting diode LD1 and the second light emitting diode LD2 may emit light. In an embodiment, the first light emitting diode LD1 and the second light emitting diode LD2 may emit light simultaneously when the global transistor TRg is turned on by the global signal GLS.

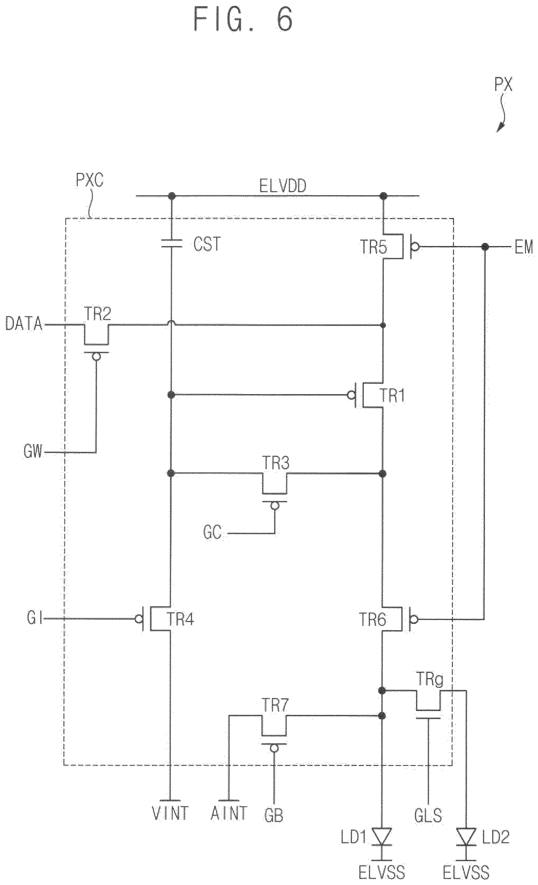

FIG. 6 is a circuit diagram illustrating an example of FIG. 5.

Referring to FIGS. 5 and 6, the pixel PX may be driven through the pixel circuit PXC. The pixel PX may include the pixel circuit PXC, and the first light emitting diode LD1 and the second light emitting diode LD2 which are connected to the pixel circuit PXC. The pixel circuit PXC may include a plurality of transistors TR and at least one capacitor CST.

In an embodiment, the pixel circuit PXC may include a first transistor TR1, a second transistor TR2, a third transistor TR3, a fourth transistor TR4, a fifth transistor TR5, a sixth transistor TR6, a seventh transistor TR7, a global transistor TRg, and a storage capacitor CST.

The first transistor TR1 may include a first gate terminal, a first source terminal, and a first drain terminal. The first source terminal of the first transistor TR1 may be electrically connected to a first node. The first source terminal of the first transistor TR1 may receive the data voltage DATA. The first drain terminal of the first transistor TR1 may be electrically connected to a light emitting element such as a light emitting diode through the sixth transistor TR6. The first transistor TR1 may generate a driving current. For example, the first transistor TR1 may be referred to as a driving transistor TRd.

The second transistor TR2 may include a second gate terminal, a second source terminal, and a second drain terminal. The second gate terminal of the second transistor TR2 may receive the first gate signal GW through the gate line. For example, the first gate signal GW may be referred to as a write gate signal GW. The second source terminal of the second transistor TR2 may receive the data voltage DATA through the data line. The second drain terminal of the second transistor TR2 may provide the data voltage DATA to the first node during a period in which the second transistor TR2 is turned on.

The second transistor TR2 may be turned on or off in response to the first gate signal GW. For example, when the second transistor TR2 is a PMOS transistor, the second transistor TR2 may be turned off when the first gate signal GW has a positive voltage level, and may be turned on when the first gate signal GW has a negative voltage level. For example, the second transistor TR2 may be referred to as a switching transistor.

The third transistor TR3 may include a third gate terminal, a third source terminal, and a third drain terminal. The third gate terminal of the third transistor TR3 may receive a second gate signal GC. For example, the second gate signal GC may be referred to as a compensation control signal GC.

The third transistor TR3 may be turned on or off in response to the second gate signal GC. For example, when the third transistor TR3 is a PMOS transistor, the third transistor TR3 may be turned off when the second gate signal GC has a positive voltage level, and may be turned on when the second gate signal GC has a negative voltage level. During a period in which the third transistor TR3 is turned on in response to the second gate signal GC, the third transistor TR3 may diode-connect the first transistor TR1. Accordingly, the third transistor TR3 may compensate for the threshold voltage of the first transistor TR1. For example, the third transistor TR3 may be referred to as a compensation transistor. However, embodiments according to the invention are not limited thereto, and the third transistor TR3 may further include a third back-gate terminal and may be an NMOS transistor.

The fourth transistor TR4 may include a fourth gate terminal, a fourth source terminal, and a fourth drain terminal. The fourth gate terminal of the fourth transistor TR4 may receive a third gate signal GI. For example, the third gate signal GI may be referred to as an initialization gate signal GI.

The fourth source terminal of the fourth transistor TR4 may be connected to the first gate terminal of the first transistor TR1. The fourth drain terminal of the fourth transistor TR4 may be connected to the transistor initialization voltage VINT. The fourth transistor TR4 may connect the first gate terminal of the first transistor TR1 and the transistor initialization voltage VINT.

The fourth transistor TR4 may be turned on or off in response to the third gate signal GI. For example, when the fourth transistor TR4 is a PMOS transistor, the fourth transistor TR4 may be turned off when the third gate signal GI has a positive voltage level, and may be turned on when the third gate signal GI has a negative voltage level.

During a period in which the fourth transistor TR4 is turned on in response to the third gate signal GI, the first gate terminal of the first transistor TR1 may receive the transistor initialization voltage VINT. Accordingly, the fourth transistor TR4 may transmit the transistor initialization voltage VINT to the first gate terminal of the first transistor TR1 in response to the third gate signal GI. For example, the fourth transistor TR4 may be referred to as an initialization transistor.

However, embodiments according to the invention are not limited thereto, and the fourth transistor TR4 may further include a fourth back-gate terminal and may be an NMOS transistor.

The fifth transistor TR5 may include a fifth gate terminal, a fifth source terminal, and a fifth drain terminal. The fifth gate terminal of the fifth transistor TR5 may receive the light emission driving signal EM. The fifth source terminal of the fifth transistor TR5 may receive a high power supply voltage ELVDD. The fifth drain terminal of the fifth transistor TR5 may be connected to the first node. When the fifth transistor TR5 is turned on in response to the light emission driving signal EM, the fifth transistor TR5 may provide the high power supply voltage ELVDD to the first transistor TR1.

The sixth transistor TR6 may include a sixth gate terminal, a sixth source terminal, and a sixth drain terminal. The sixth gate terminal of the sixth transistor TR6 may receive the light emission driving signal EM. The sixth source terminal of the sixth transistor TR6 may be connected to the first transistor TR1. The sixth drain terminal of the sixth transistor TR6 may be connected to the light emitting diode. When the sixth transistor TR6 is turned on in response to the light emission driving signal EM, the sixth transistor TR6 may provide the driving current to the light emitting diode. For example, each of the fifth transistor TR5 and the sixth transistor TR6 may be referred to as an emission control transistor.

The seventh transistor TR7 may include a seventh gate terminal, a seventh source terminal, and a seventh drain terminal. The seventh gate terminal of the seventh transistor TR7 may receive a fourth gate signal GB. For example, the fourth gate signal GB may be referred to as a bypass gate signal GB. The seventh source terminal of the seventh transistor TR7 may be connected to the light emitting diode. The seventh drain terminal of the seventh transistor TR7 may receive the anode initialization voltage AINT. When the seventh transistor TR7 is turned on in response to the fourth gate signal GB, the seventh transistor TR7 may provide the anode initialization voltage AINT to the first light emitting diode LD1. Accordingly, the seventh transistor TR7 may initialize the first terminal of the first light emitting diode LD1 by the anode initialization voltage AINT. For example, the seventh transistor TR7 may be referred to as an anode initialization transistor.

The storage capacitor CST may include a first terminal and a second terminal. The first terminal of the storage capacitor CST may be connected to the first transistor TR1, and the second terminal of the storage capacitor CST may receive the high power voltage ELVDD. The storage capacitor CST may maintain the voltage level of the first gate terminal of the first transistor TR1 during an inactive period of the first gate signal GW.

The first light emitting diode LD1 may include the first anode terminal and the first cathode terminal. The first anode terminal of the first light emitting diode LD1 may be connected to the sixth transistor TR6 to receive the driving current, and the first cathode terminal may receive the low power voltage ELVSS. The first light emitting diode LD1 may generate light having a luminance corresponding to the driving current.

The global transistor TRg may include a global gate terminal, a global source terminal, and a global drain terminal. The global gate terminal of the global transistor TRg may receive the global signal GLS through the signal line (e.g., the signal line SL of FIG. 2). The global source terminal of the global transistor TRg may be connected to the first light emitting diode LD1, and the global drain terminal may be connected to the second light emitting diode LD2. The global gate terminal may be turned on and off by the global signal GLS. The global drain terminal may provide the driving current to the second light emitting diode LD2 during a period when the global transistor TRg is turned on.

The global transistor TRg may be turned on or off in response to the global signal GLS. For example, when the global transistor TRg is an NMOS transistor, the global transistor TRg may be turned on when the global signal GLS has a positive voltage level, and the global signal GLS may be turned off when the global signal GLS has a negative voltage level.

The second light emitting diode LD2 may include a second anode terminal and a second cathode terminal. The second anode terminal of the second light emitting diode LD2 may be connected to the global transistor TRg to receive the driving current, and the second cathode terminal may receive the low power supply voltage ELVSS. The second light emitting diode LD2 may generate light having a luminance corresponding to the driving current.

In an embodiment, as the global transistor TRg connected to the first light emitting diode LD1 and the second light emitting diode LD2 is turned on or off in response to the global signal GLS, the second light emitting diode LD2 may receive the driving current even if the second light emitting diode LD2 does not include a separate transistor. Accordingly, the display device 10 including the pixels PX may adjust the viewing angle without reducing resolution.

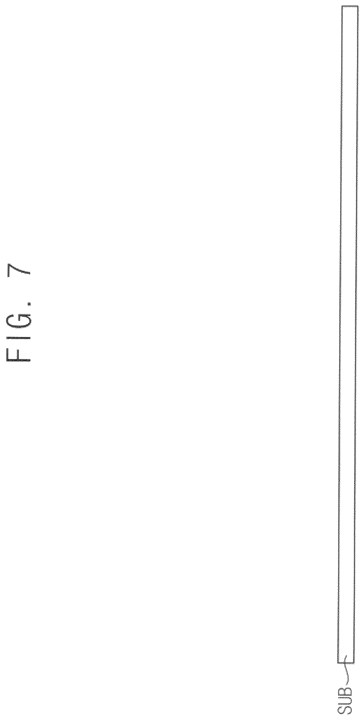

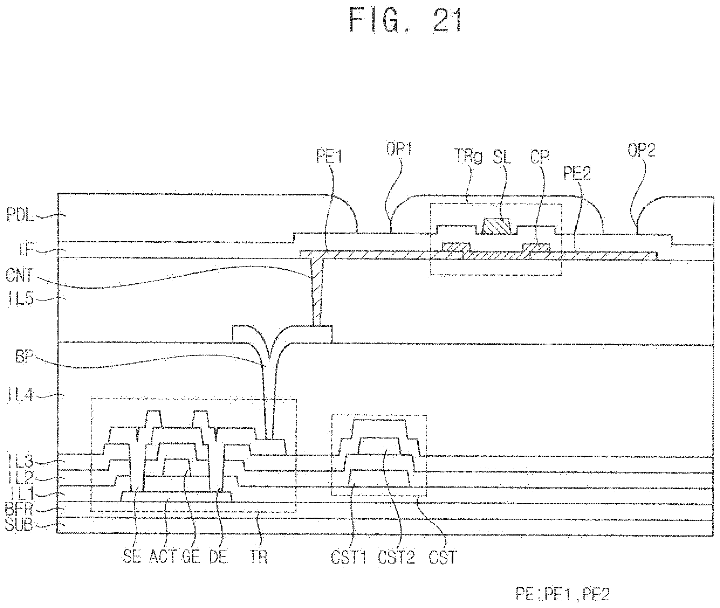

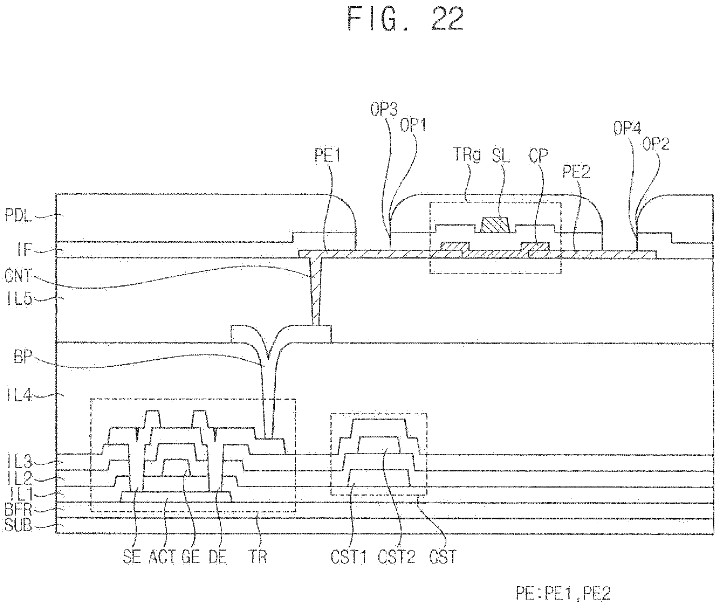

FIGS. 7 to 25 are views for explaining a method of manufacturing (or providing) a display device 10 according to an embodiment.

A method of manufacturing a display device described with reference to FIGS. 7 to 25 may be the method of manufacturing the display device 10 described with reference to FIGS. 1 to 4. Accordingly, a portion overlapping with the description of the display device 10 described with reference to FIGS. 1 to 4 may be omitted.

FIGS. 7 to 9 are cross-sectional views illustrating a method of manufacturing a display device 10 according to an embodiment.

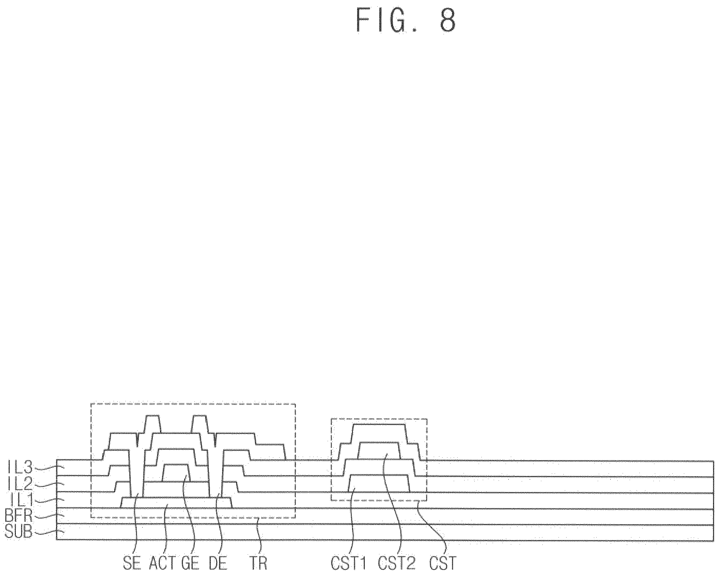

Referring to FIGS. 7 and 8, a buffer layer BFR may be formed (or provided) on a substrate SUB. A transistor TR and insulation layers IL1, IL2, and IL3 may be formed on the buffer layer BFR.

The active layer ACT may be formed on the buffer layer BFR. A first insulation layer IL1 may be formed on the buffer layer BFR to cover the active layer ACT. A gate electrode GE and a first capacitor electrode CST1 may be formed on the first insulation layer IL1. A second insulation layer IL2 may be formed on the first insulation layer IL1 to cover the gate electrode GE and the first capacitor electrode CST1. A second capacitor electrode CST2 may be formed on the second insulation layer IL2. The first capacitor electrode CST1 and the second capacitor electrode CST2 may form a storage capacitor CST.

A third insulation layer IL3 may be formed on the second insulation layer IL2 to cover the second capacitor electrode CST2. A source electrode SE and a drain electrode DE may be formed on the third insulation layer IL3. The active layer ACT, the gate electrode GE, the source electrode SE, and the drain electrode DE may form the transistor TR.

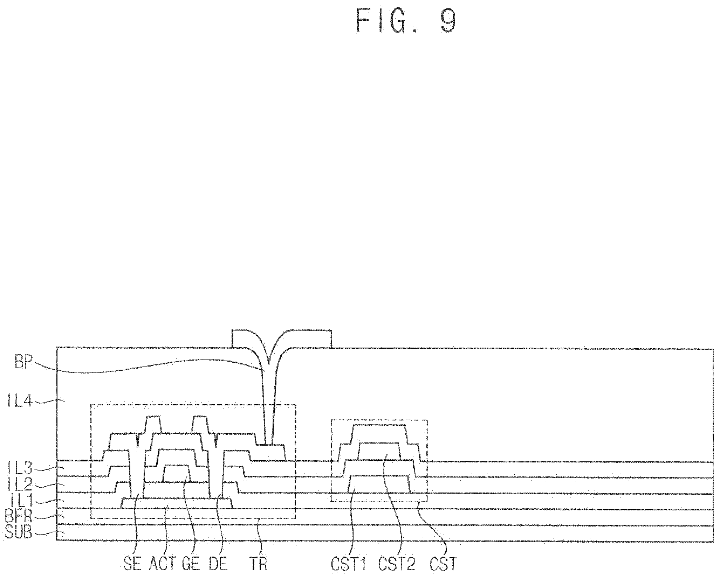

Referring further to FIG. 9, a fourth insulation layer IL4 may be formed on the third insulation layer IL3 to cover the source electrode SE and the drain electrode DE. A respective contact hole exposing a portion of the source electrode SE or the drain electrode DE may be formed in the fourth insulation layer IL4.

A bridge pattern BP may be formed on the fourth insulation layer IL4. The bridge pattern BP may contact the source electrode SE or the drain electrode DE through the respective contact hole.

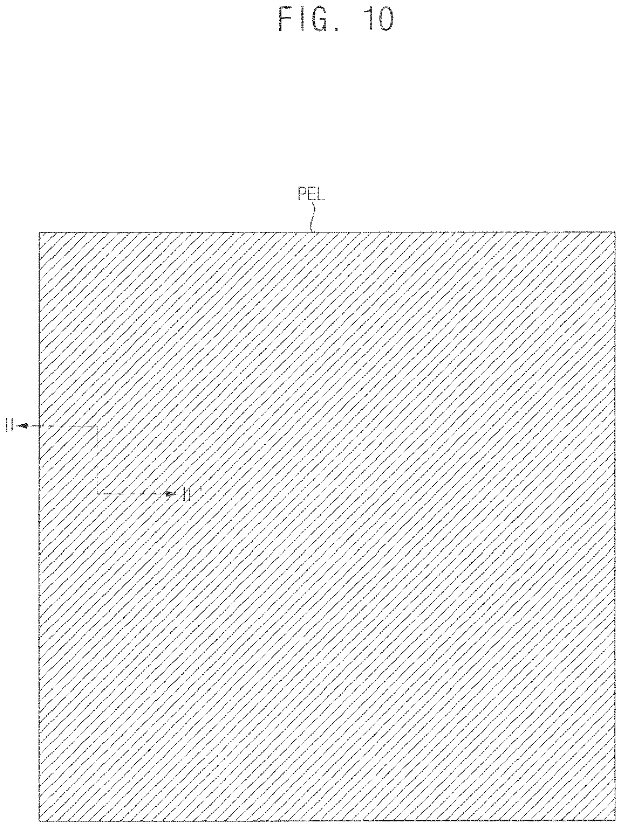

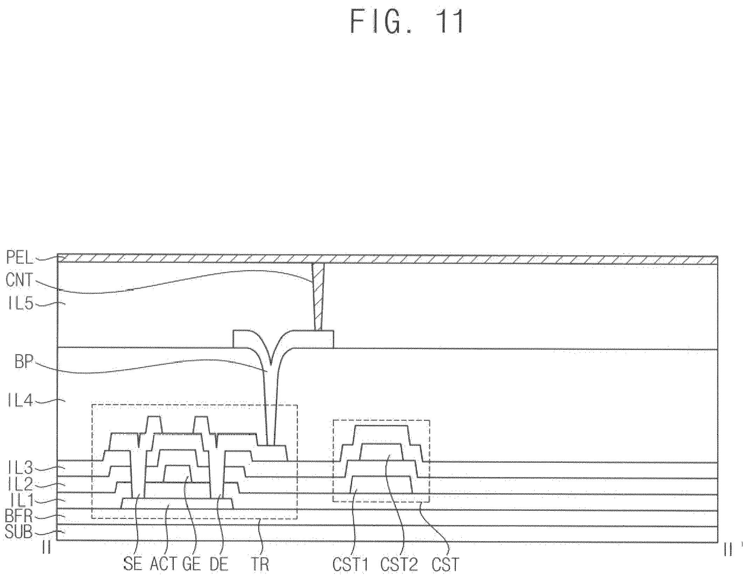

FIG. 10 is a plan view illustrating the method of manufacturing the display device 10 according to an embodiment, and FIG. 11 is a cross-sectional view taken along line II-II' of FIG. 10.

Referring further to FIGS. 10 and 11, a fifth insulation layer IL5 may be formed on the fourth insulation layer IL4 to cover the bridge pattern BP. A contact hole CNT exposing a portion of the bridge pattern BP to outside the fourth insulation layer IL4, may be formed in the fifth insulation layer IL5.

A pixel electrode layer PEL may be formed on the fifth insulation layer IL5. The pixel electrode layer PEL may contact the bridge pattern BP through the contact hole CNT. Accordingly, the pixel electrode layer PEL may be connected to the transistor TR through the bridge pattern BP.

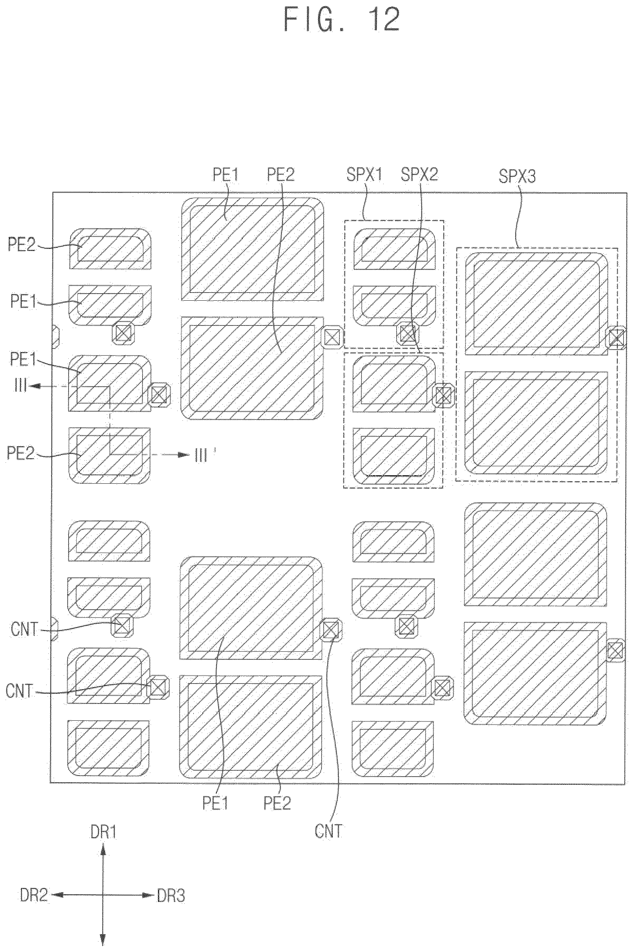

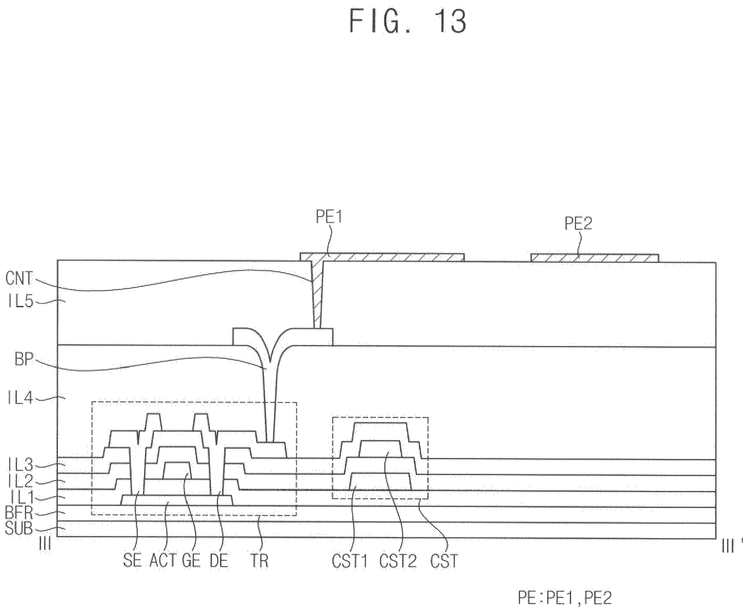

FIG. 12 is a plan view illustrating the method of manufacturing the display device 10 according to an embodiment, and FIG. 13 is a cross-sectional view taken along line III-III' of FIG. 12.

Referring further to FIGS. 12 and 13, first pixel electrodes PE1 and second pixel electrodes PE2 may be formed by patterning the pixel electrode layer PEL. Each of the first pixel electrodes PE1 and the second pixel electrodes PE2 may be included in one sub-pixel. The second pixel electrode PE2 may be formed adjacent to the first pixel electrode PE1 in (or along) the first direction DR1.

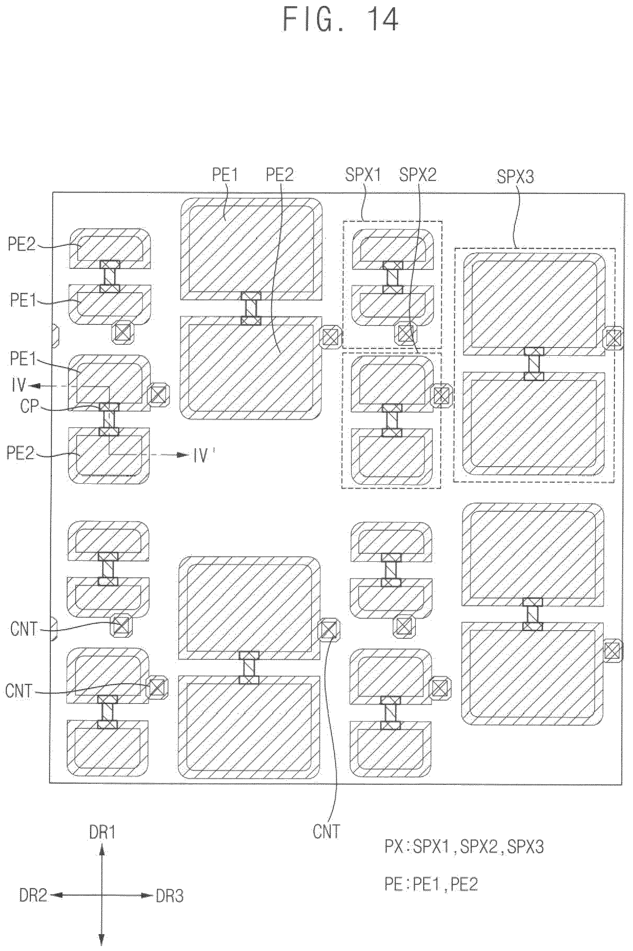

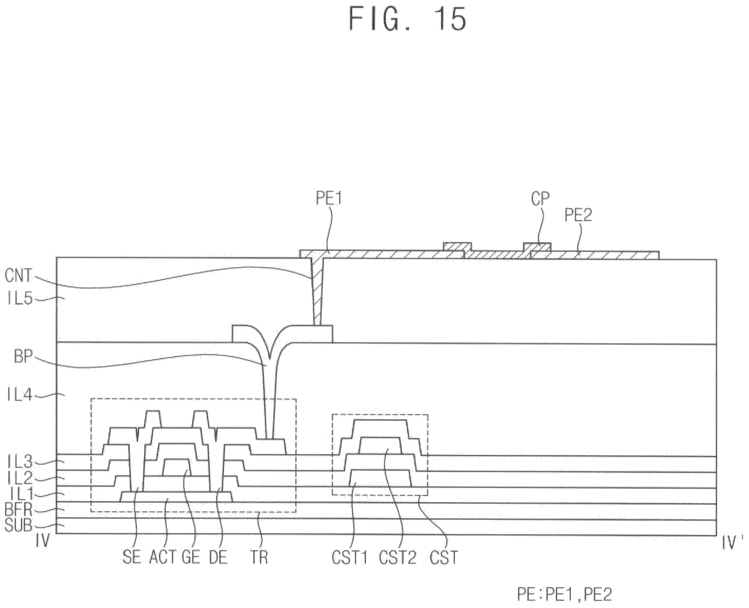

FIG. 14 is a plan view illustrating the method of manufacturing the display device 10 according to an embodiment, and FIG. 15 is a cross-sectional view taken along line IV-IV' of FIG. 14.

Referring further to FIGS. 14 and 15, a connection pattern CP contacting the first pixel electrode PE1 and the second pixel electrode PE2 may be formed on the first pixel electrode PE1 and the second pixel electrode PE2. The connection pattern CP may extend in a first direction DR1 and may connect the first pixel electrode PE1 and the second pixel electrode PE2 to each other.

The connection pattern CP may be formed of a semi-conductive material. For example, the connection pattern CP may be formed of Indium-Gallium-Zinc Oxide (IGZO).

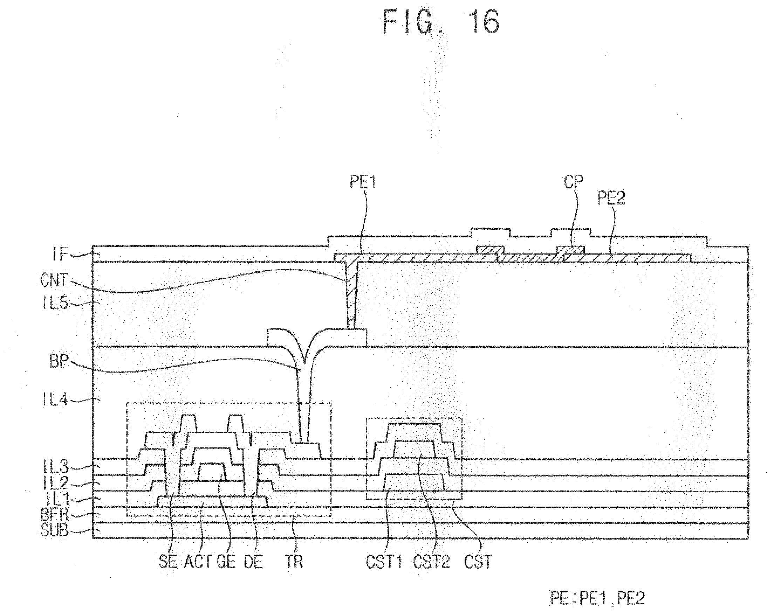

FIG. 16 is a cross-sectional view illustrating the method of manufacturing the display device 10 according to an embodiment.

Referring further to FIG. 16, an insulation film IF may be formed on the first pixel electrode PE1, the second pixel electrode PE2, and the connection pattern CP. The insulation film IF may be formed on the fifth insulation layer IL5 to cover the first pixel electrode PE1, the second pixel electrode PE2, and the connection pattern CP. The insulation film IF may be formed of an inorganic material.

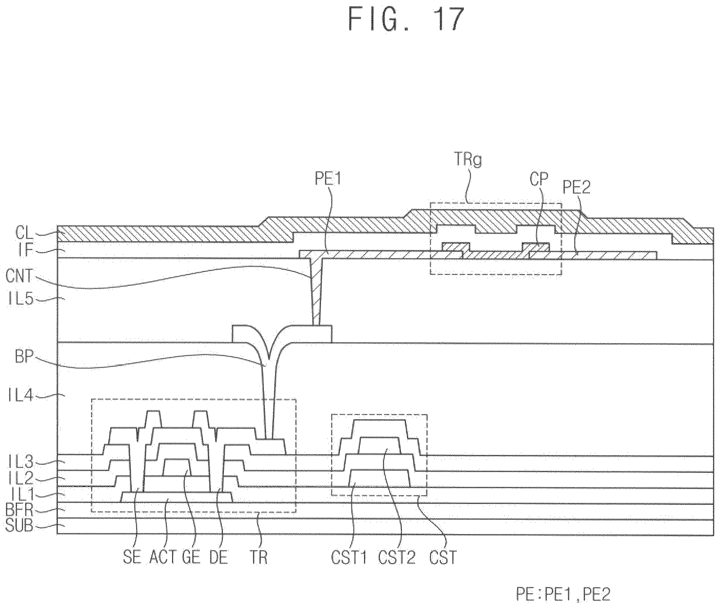

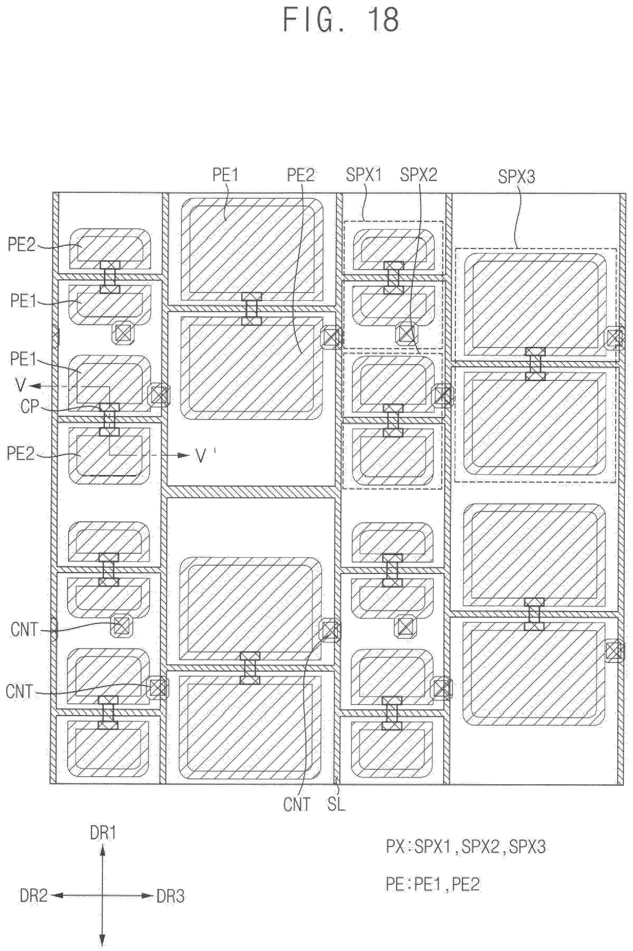

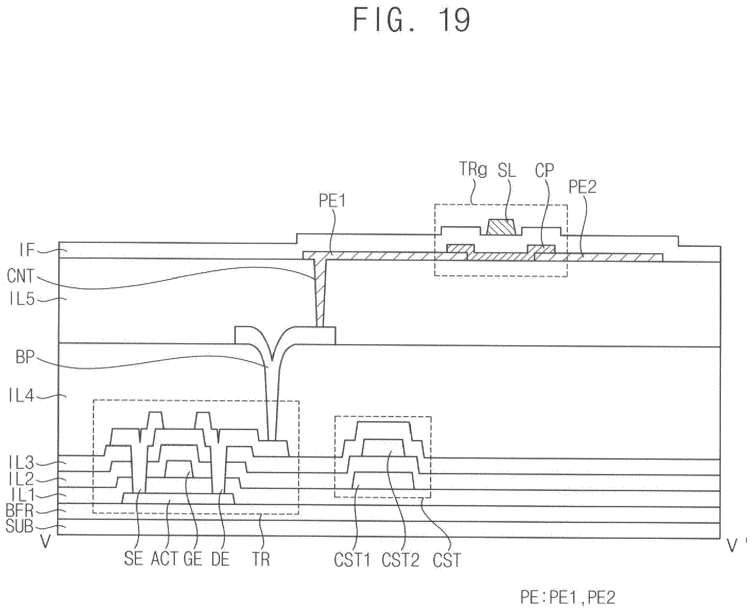

FIG. 17 is a cross-sectional view illustrating the method of manufacturing the display device 10 according to an embodiment of the invention, FIG. 18 is a plan view illustrating the method of manufacturing the display device 10 according to an embodiment of the invention, and FIG. 19 is a cross-sectional view taken along the line V-V' of FIG. 18.

Referring further to FIGS. 17 to 19, a conductive layer CL may be formed on the insulation film IF. The conductive layer CL may be formed of a metal. The conductive layer CL may be formed of the same material as the gate electrode GE. Examples of the material for forming the conductive layer CL may include silver (Ag), an alloy containing silver, molybdenum (Mo), an alloy containing molybdenum, aluminum (Al), an alloy containing aluminum, aluminum Nitride (AlN), tungsten (W), tungsten nitride (WN), copper (Cu), nickel (Ni), chromium (Cr), chromium nitride (CrN), titanium (Ti), tantalum (Ta), platinum (Pt), scandium (Sc), indium tin oxide (ITO), indium zinc oxide (IZO), etc. These materials may be used alone or in combination.

A signal line SL may be formed by patterning the conductive layer CL. The signal line SL may be formed to be spaced apart from the first pixel electrodes PE1 and the second pixel electrodes PE2 in the plan view. Also, the signal line SL may be disposed between the first pixel electrodes PE1 and the second pixel electrodes PE2 in the plan view. The signal line SL may be formed in a mesh shape.

The signal line SL may cross the connection pattern CP extending in the first direction DR1 between the first pixel electrode PE1 and the second pixel electrode PE2. That is, the signal line SL may be formed to overlap the connection pattern CP. The signal line SL and the connection pattern CP may form portions of a global transistor TRg.

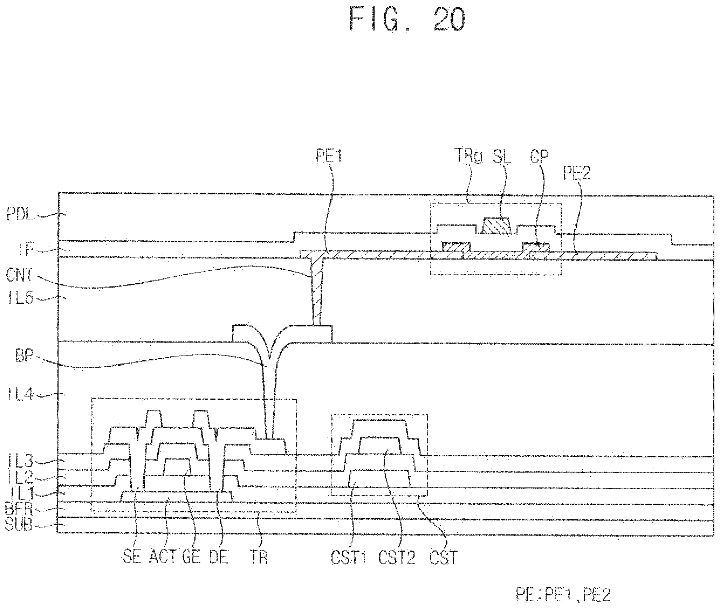

FIGS. 20 to 23 are cross-sectional views illustrating the method of manufacturing the display device 10 according to an embodiment.

Referring further to FIGS. 20 to 22, a pixel defining layer PDL may be formed on the insulation film IF and the signal line SL. A first opening OP1 overlapping the first pixel electrode PE1 and a second opening OP2 overlapping the second pixel electrode PE2, may be respectively formed in the pixel defining layer PDL. A third opening OP3 overlapping the first opening OP1 and a fourth opening OP4 overlapping the second opening OP2 may be respectively formed in the insulation film IF.

The first opening OP1 and the third opening OP3 may expose the first pixel electrode PE1 to outside an insulating layer (e.g., the pixel defining layer PDL together with the insulation film IF). The second opening OP2 and the fourth opening OP4 may expose the second pixel electrode PE2.

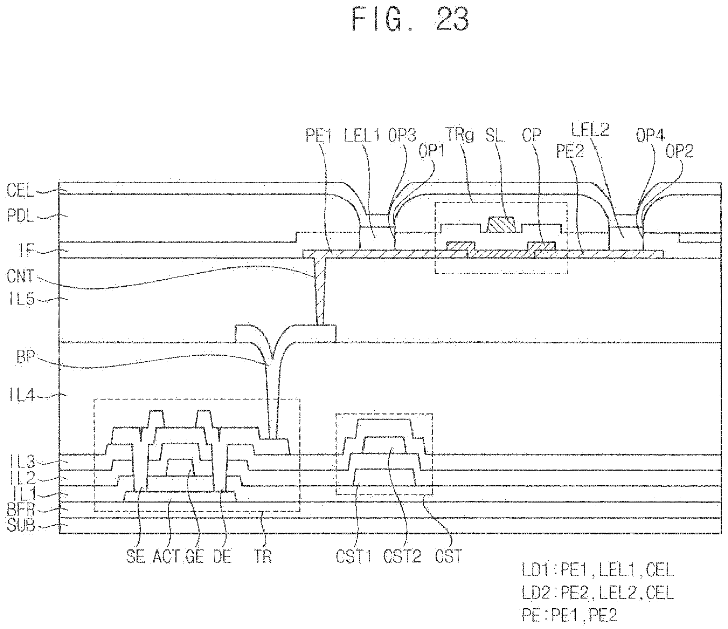

Referring further to FIG. 23, a first light emitting layer LEL1 may be formed in the first opening OP1 and the third opening OP3, and a second light emitting layer LEL2 may be formed in the second opening OP2 and the fourth opening OP4. A common electrode layer CEL may be formed on the pixel defining layer PDL to cover the first light emitting layer LEL1 and the second light emitting layer LEL2.

The first pixel electrode PE1, the first light emitting layer LEL1, and the common electrode layer CEL may form a first light emitting diode LD1, and the second pixel electrode PE2, the second light emitting layer LEL2, and the common electrode layer CEL may form a second light emitting diode LD2. The first light emitting diode LD1 and the second light emitting diode LD2 may separately emit light.

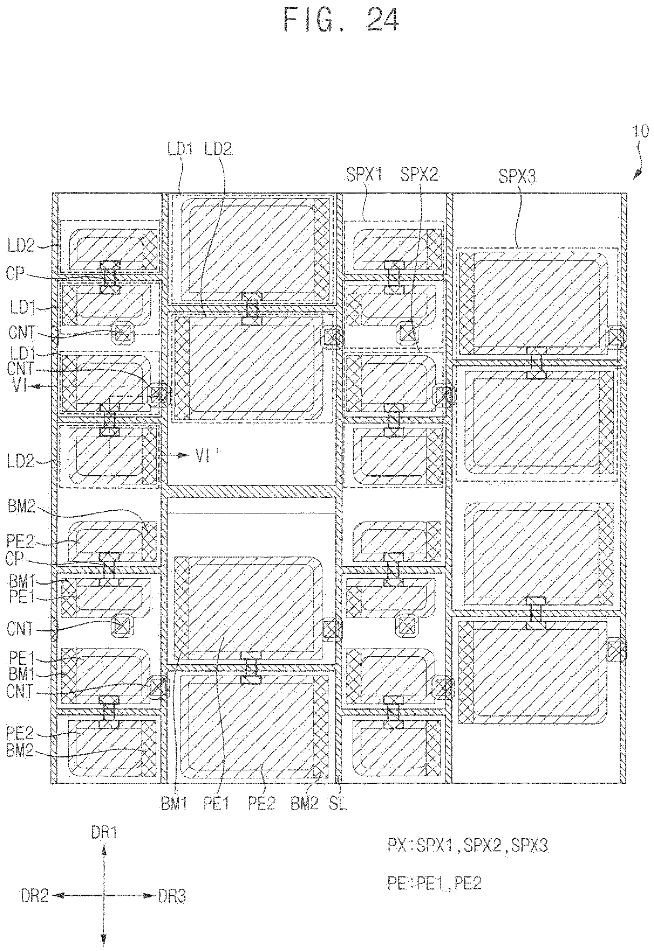

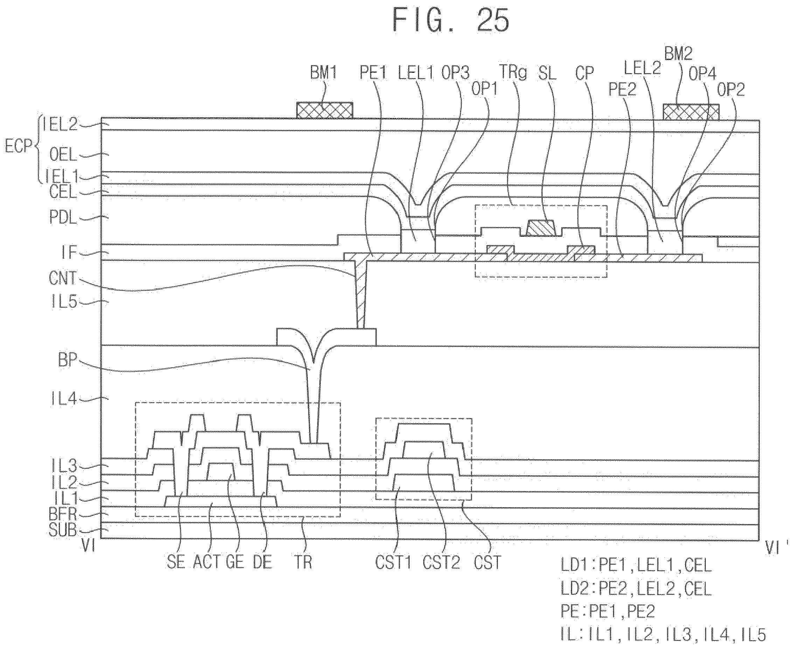

FIG. 24 is a plan view illustrating the method of manufacturing the display device 10 according to an embodiment, and FIG. 25 is a cross-sectional view taken along line VI-VI' of FIG. 24.

Referring further to FIGS. 24 and 25, an encapsulation layer ECP may be formed on the common electrode layer CEL. A first inorganic encapsulation layer IEL1 may be formed on the common electrode layer CEL, an organic encapsulation layer OEL may be formed on the first inorganic encapsulation layer IEL1, and a second organic encapsulation layer IEL2 may be formed on the organic encapsulation layer OEL.

The first black matrix BM1 provided in plural including first black matrices BM1 and the second black matrix BM2 provided in plural including second black matrices BM2, may be formed on the encapsulation layer ECP. At least one first black matrix BM1 and at least one second black matrix BM2 may be formed in one sub-pixel SPX. The second black matrix BM2 may be formed to be spaced apart from the first black matrix BM1 within the same sub-pixel. Each of the first black matrices BM1 and the second black matrices BM2 may be formed of a black pigment, a black dye, or a conductive material.

Referring to the plan view of FIG. 24, the first black matrix BM1 included in the one sub-pixel SPX may overlap the first pixel electrode PE1, and may be formed on the first pixel electrode PE1 in the second direction DR2 with respect to a center of the first pixel electrode PE1. The second black matrix BM2 may be formed on the second pixel electrode PE2 in the third direction DR3 with respect to a center of the second pixel electrode PE2. However, embodiments according to the invention are not limited thereto.

As discussed, embodiments can provide a display device comprising: a transistor; a first pixel electrode electrically connected to the transistor; a second pixel electrode adjacent to the first pixel electrode and electrically connectable to the first pixel electrode by a global transistor (or connection transistor); a connection pattern of the global transistor, the connection pattern contacting the first pixel electrode and the second pixel electrode; an insulation film on the first pixel electrode, the second pixel electrode and the connection pattern; and a signal line of the global transistor, on the insulation film and crossing the connection pattern, in a plan view.

A signal applied to the signal line may turn on or off the global transistor, and hence may selectively electrically connect the first pixel electrode to the second pixel electrode.

The display device may comprise a plurality of sub-pixels. For example, first to third sub-pixels may form a pixel, and the display device may comprise a plurality of pixels.

Each sub-pixel may include two light emitting elements, such as two light emitting diodes. A global (or connection) transistor may be formed in each sub-pixel. A global signal may be applied to all the global (or connection) transistors to turn them all on or off at once. For example, the signal line may turn on or off all the global transistors.

The first pixel electrode may be a pixel electrode for the first light emitting diode, and the second pixel electrode may be a pixel electrode for the second light emitting diode. A common electrode may be formed over all the sub-pixels. The common electrode may form part of a common electrode layer.

The first pixel electrode and the second pixel electrode may be on a same layer and may include the same material. The transistor may include an active layer and a gate electrode overlapping the active layer, and the signal line and the gate electrode may include the same material.

The first pixel electrode, a first light emitting layer, and the common electrode layer may together constitute the first light emitting diode, and the second pixel electrode, a second light emitting layer, and the common electrode layer together may constitute the second light emitting diode.

The transistor may control a driving current (e.g., electrical driving current) flowing in the first and second light emitting diodes. The global transistor may control a driving current flowing in the second light emitting diode. Hence, the global transistor determines if first and second light emitting diodes emit light (depending on the transistor) or if only the first light emitting diode emits light (depending on the transistor).

The signal line may be disposed between the first pixel electrode and the second pixel electrode. The signal line may cross the connection pattern connecting the first pixel electrode and the second pixel electrode, in a plan view.

The signal line may be spaced apart from the first pixel electrodes and the second pixel electrodes, and may have a mesh shape, in the plan view. The signal line and the connection pattern may constitute portions of the global transistor.

The connection pattern may include a semi-conductive material. For example, the connection pattern may include Indium-Gallium-Zinc Oxide (IGZO).

The global transistor may include a global gate terminal, a global source terminal, and a global drain terminal. A global signal may be applied to the global gate terminal of the global transistor. The global source terminal of the global transistor may be connected to the first light emitting diode, and the global drain terminal may be connected to the second light emitting diode. The global gate terminal may be turned on and off by the global signal. That is, the second pixel electrode which is adjacent to the first pixel electrode, is connectable to the first pixel electrode by the global transistor.

When the global transistor is turned off by the global signal, current (e.g., electrical current) may flow only in the first light emitting diode. That is, no current may flow in the second light emitting diode when the global transistor is turned off by the global signal. Accordingly, the second light emitting diode may not emit light, and only the first light emitting diode may emit light when the global transistor is turned off.

A first black matrix may determine a viewing angle of the first light emitting diode, and second black matrix may determine a viewing angle of the second light emitting diode.

The viewing angle of the first light emitting diode emitting alone may be different to the viewing angle obtained when the first light emitting diode and the second light emitting diode are both emitting.

In some embodiments, as the sub-pixel which emits light of a single color and is included in the display device includes the first pixel electrode and the second pixel electrode connectable or disconnectable to and from each other, respectively, and includes a global transistor connecting and disconnecting the first pixel electrode and the second pixel electrode, the first light emitting diode including the first pixel electrode and the second light emitting diode including the second pixel electrode may selectively emit light by the global signal applied to the global transistor. Accordingly, it may be possible to adjust the viewing angle of the display device without reducing the resolution of the display device.

Embodiments can provide a display device including: a plurality of pixels emitting light of different colors from each other, and each pixel among the plurality of pixels comprising: a transistor through which electrical current is provided to the each pixel; a first light emitting diode electrically connected to the transistor; a second light emitting diode adjacent to the first light emitting diode and electrically connectable to the first light emitting diode; and a global (or connection) transistor arranged to receive an electrical signal and electrically connectable to the first light emitting diode.

Embodiments can provide a method of providing a display device, the method comprising: providing a pixel electrode layer connected to a transistor; providing a first pixel electrode and a second pixel electrode which is adjacent to the first pixel electrode and electrically connectable to the first pixel electrode, by patterning the pixel electrode layer; providing a connection pattern of a global (or connection) transistor which contacts the first pixel electrode and the second pixel electrode; providing a signal line of the global transistor which crosses the connection pattern in a plan view; and providing an insulation film between the signal line, and each of the connection pattern, the first pixel electrode and the second pixel electrode, respectively.

Embodiments of the display devices and the methods thereof may be applied to a display device 10 included in a computer, a notebook, a mobile phone, a smartphone, a smart pad, a PMP, a PDA, an MP3 player, or the like.

Although embodiments of the display devices and the methods thereof have been described with reference to the drawings, the illustrated embodiments are examples, and may be modified and changed by a person having ordinary knowledge in the relevant technical field.

## Claims

1. A display device comprising:
a transistor;
a first pixel electrode connected to the transistor;
a second pixel electrode adjacent to the first pixel electrode and connectable to the first pixel electrode by a global transistor;
a connection pattern of the global transistor, the connection pattern contacting the first pixel electrode and the second pixel electrode;
an insulation film on the first pixel electrode, the second pixel electrode and the connection pattern; and
a signal line of the global transistor, on the insulation film and crossing the connection pattern, in a plan view.

2. The display device of claim 1, wherein the signal line is spaced apart from and between the first pixel electrode and the second pixel electrode, in the plan view.

3. The display device of claim 2, wherein the signal line has a mesh shape, in the plan view.

4. The display device of any one of claims 1 to 3, wherein the first pixel electrode and the second pixel electrode are on a same layer and include the same material.

5. The display device of any one of claims 1 to 4, wherein the connection pattern includes indium-gallium-zinc oxide.

6. The display device of any one of claims 1 to 5, further comprising:
a bridge pattern which connects the transistor and the first pixel electrode to each other, the bridge pattern overlapping both the transistor and the first pixel electrode and being spaced apart from the second pixel electrode, in the plan view.

7. The display device of any one of claims 1 to 6, wherein the transistor includes an active layer and a gate electrode overlapping the active layer;
optionally wherein the signal line and the gate electrode include the same material.

8. The display device of any one of claims 1 to7, further comprising:
a pixel defining layer on the insulation film and the signal line, the pixel defining layer defining a first opening corresponding to the first pixel electrode and a second opening corresponding to the second pixel electrode;
a first light emitting layer in the first opening;
a second light emitting layer in the second opening; and
a common electrode layer on the first light emitting layer, the second light emitting layer and the pixel defining layer;
optionally further comprising: a first black matrix on the common electrode layer and overlapping the first pixel electrode; and a second black matrix on the common electrode layer, overlapping the second pixel electrode, and spaced apart from the first black matrix in the plan view;
optionally wherein the first pixel electrode and the second pixel electrode are adjacent each other along a first direction, each of the first pixel electrode and the second pixel electrode includes a first end and a second end opposing each other along a second direction crossing the first direction, the first black matrix overlaps the first end of the first pixel electrode, and the second black matrix overlaps the second end of the second pixel electrode.

9. A display device including:
a plurality of pixels emitting light of different colors from each other, and
each pixel among the plurality of pixels comprising:
a transistor through which electrical current is provided to the each pixel;
a first light emitting diode connected to the transistor;
a second light emitting diode adjacent to the first light emitting diode and connectable to the first light emitting diode; and
a global transistor which receives an electrical signal and is connected to the first light emitting diode.

10. The display device of claim 9, wherein the global transistor is turned on by receiving the electrical signal and is turned off by absence of the electrical signal;
optionally wherein the global transistor when turned off, disconnects the second light emitting diode from the first light emitting diode, and the electrical current flows in the first light emitting diode, and the global transistor when turned on, connects the second light emitting diode to the first light emitting diode, and the electrical current flows in both the first light emitting diode and the second light emitting diode.

11. A method of providing a display device, the method comprising:
providing a pixel electrode layer connected to a transistor;
providing a first pixel electrode and a second pixel electrode which is adjacent to the first pixel electrode and connectable to the first pixel electrode, by patterning the pixel electrode layer;
providing a connection pattern of a global transistor which contacts the first pixel electrode and the second pixel electrode;
providing a signal line of the global transistor which crosses the connection pattern in a plan view; and
providing an insulation film between the signal line, and each of the connection pattern, the first pixel electrode and the second pixel electrode, respectively.

12. The method of claim 11, further comprising:
providing a pixel defining layer on the insulation film and the signal line;
providing a first opening overlapping the first pixel electrode and a second opening overlapping the second pixel electrode, in the pixel defining layer; and
in the insulation film, providing a third opening overlapping the first opening and a fourth opening overlapping the second opening,
wherein
the first and third openings together expose the first pixel electrode to outside the pixel defining layer and the insulation film, and
the second and fourth openings together expose the second pixel electrode to outside the pixel defining layer and the insulation film;
optionally further comprising: providing a common electrode layer on the pixel defining layer; and providing a black matrix layer on the common electrode layer, the black matrix layer including a first black matrix overlapping the first pixel electrode and a second black matrix overlapping the second pixel electrode.

13. The method of claim 11 or 12, wherein the providing of the signal line of the global transistor includes:
providing a conductive layer on the insulation film; and
patterning the conductive layer to provide the signal line having a mesh shape.

14. The method of any one of claims 11 to 13, wherein the signal line of the global transistor is spaced apart from and between the first pixel electrode and the second pixel electrode, in the plan view.

15. The method of any one of claim 11 to 14, wherein the connection pattern includes indium-gallium-zinc oxide.
